(19) Europäisches Patentamt
European Patent Office
Office européen des brevets

(11) **EP 2 380 937 B1**

(12) **EUROPEAN PATENT SPECIFICATION**

(45) Date of publication and mention
of the grant of the patent:
**15.02.2017 Bulletin 2017/07**

(51) Int Cl.:
*C09D 11/10* (2014.01)  *C08G 18/34* (2006.01)
*H05K 3/28* (2006.01)  *C08G 18/08* (2006.01)
*C08G 18/66* (2006.01)

(21) Application number: **09833369.3**

(22) Date of filing: **09.12.2009**

(86) International application number:
**PCT/JP2009/070611**

(87) International publication number:
**WO 2010/071065 (24.06.2010 Gazette 2010/25)**

(54) **HEAT-CURABLE INK COMPOSITION**

WÄRMEHÄRTBARE TINTENZUSAMMENSETZUNG

COMPOSITION D'ENCRE THERMODURCISSABLE

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **19.12.2008 JP 2008323633**

(43) Date of publication of application:
**26.10.2011 Bulletin 2011/43**

(73) Proprietor: **SHOWA DENKO K.K.
Minato-ku, Tokyo 105-8518 (JP)**

(72) Inventors:
• **KIMURA, Kazuya
Tokyo 105-8518 (JP)**

• **UMINO, Atsushi
Tokyo 105-0012 (JP)**
• **AZUMA, Ritsuko
Tokyo 105-8518 (JP)**

(74) Representative: **Strehl Schübel-Hopf & Partner
Maximilianstrasse 54
80538 München (DE)**

(56) References cited:
**EP-A1- 0 844 261    WO-A1-02/36697
WO-A2-03/006561    JP-A- 55 048 244
JP-A- 2007 100 038**

EP 2 380 937 B1

**Description**

FIELD OF THE INVENTION

The present invention relates to a flexible printed wiring board obtainable by covering the surface of a substrate with a thermosetting ink composition and curing the ink composition, the thermosetting ink composition comprising a thermosetting resin (A) having "a" in the Mark-Houwink formula of less than 0.60 wherein the formula shows the relationship of the intrinsic viscosity [η] and the absolute molecular weight M of the resin. The thermosetting ink composition has excellent balance concerning resistances to oozing and bleeding in screen printing, electric insulating properties and adhesion to an object to be coated and also capable of being favorably used for resists for insulating protecting wirings such as solder resists, protective films such as interlayer insulating films, and electronic materials such as electric insulating materials, IC, ultra LSI sealing materials, laminating boards.

BACKGROUND TECHNIQUE

In conventional resist inks, a method of using an inorganic filler has been employed as a means for improving screen printing properties for the sake of fine pitching, as shown in
JP-A-2003-113338 (Patent document 1) and JP-A-2008-214413 (Patent document 2). This method, however, has a problem such that impurities or re-aggregated substances derived from the inorganic filler cause defects of lowering the electric insulating properties.
As a means for attaining both of improving the screen-printing properties and the electric insulating reliability for the sake of fine pitching, a method of using a specific filler has been used as shown in JP-A-2007-100038 (Patent document 3). This method, however, has a problem such that the specific filler is every expensive.

PRIOR ART DOCUMENT

PATENT DOCUMENT

Patent document 1: JP-A-2003-113338
Patent document 2: JP-A-2008-214413
Patent document 3: JP-A-2007-100038
Patent Document 4: WO 2007/125806 A1

WO 02/36697 A1 discloses a liquid printing ink for flexographic and/or gravure printing comprising hyperbranched polymers as binders, wherein in one case the hyperbranched polymer is a COOH- and OH-terminated hyperbranched polyurethane obtained from isophorone diisocyanate, dimethylpropionic acid, trimethylolpropane and polytetrahydrofuran.
WO 03/006561 A2 discloses as an example of an aqueous ink composition a composition comprising a polyurethane polymer prepared from two polyesters, dimethylpropionic acid, trimethylolpropane and methylene bis(cyclohexyl isocyanate).
EP 0 844 261 A1 discloses a printing ink composition comprising a polyurethane prepared from a polyester, dimethylpropionic acid, butane-1,4-diol, isophorone diisocyanate and trimethylolpropane.
WO 2007/125806 A1 discloses a flexible printed circuit board partially or entirely covered with a cured product, a chip on film and an electronic component(claims 12-14 of WO 2007/125806 A1. Examples 1-3 of WO 2007/125806 A1 disclose the composition of the resin: a polycarbonate diol, a carboxyl group-containing dihydroxy compound and a polyisocyanate are used.

SUMMARY OF THE INVENTION

SUBJECT FOR SOLVING BY THE INVENTION

The present invention is intended to solve the problems associated with the above prior arts, and it is an object of the present invention to provide a flexible printed wiring board covered with a cured thermosetting ink composition having excellent balance in screen printing properties such that oozing and bleeding are prevented at the time of screen printing, electric insulating reliability and adhesion to an object to be coated.

MEANS FOR SOLVING THE SUBJECT

The present inventors have studied earnestly in order to solve the above subjects. As a result, they noted that since a thermosetting ink composition containing a thermosetting resin having a value "a" of less than 0.60 in the Mark-Houwink formula that shows the relationship between the intrinsic viscosity [η] and the absolute molecular weight M of the resin prevents oozing and bleeding in screen printing and does not need an excessive amount of a filler in order to improve printability, the composition does not decrease the electric insulating reliability nor the adhesion to an object to be coated. They found that the above subjects can be solved by using the thermosetting ink composition containing a thermosetting resin having a value "a" of less than 0.60 in the Mark-Houwink formula as an essential component. Thus, the present invention has been accomplished. That is to say, the present invention relates to the items described in the claims.

[EFFECT OF THE INVENTION]

Since an inorganic filler has been used in order to improve oozing and bleeding at the time of screen printing in conventional resist inks, it is feared that the electric insulating properties are lowered by impurities or re-aggregated matters and the adhesion to an object to be coated is lowered. Furthermore, the method of using a special filler that deteriorations in electric properties and adhesion are improved still has a problem in that the filler is expensive. Meanwhile since in the thermosetting ink composition used in the present invention, oozing and bleeding at the time of screen-printing are prevented and an excessive amount of the filler is not needed in order to improve printability. Therefore, the composition can form

excellent solder resists and other protective films without lowering of the electric insulating reliability and the adhesion to an object to be coated at a small cost.

BRIEF DESCRIPTION OF THE DRAWING

Fig. 1 is a figure showing a relationship between the intrinsic viscosity [η] and the absolute molecular weight M of the carboxyl group-containing polyurethane prepared in Synthetic Example 1.
Fig. 2 is a figure showing a relationship between the intrinsic viscosity [η] and the absolute molecular weight M of the carboxyl group-containing polyurethane prepared in Synthetic Example 2.
Fig. 3 is a figure showing a relationship between the intrinsic viscosity [η] and the absolute molecular weight M of the carboxyl group-containing polyurethane prepared in Synthetic Example 3.
Fig. 4 is a figure showing a relationship between the intrinsic viscosity [η] and the absolute molecular weight M of the carboxyl group-containing polyurethane prepared in Synthetic Example 4.
Fig. 5 is a figure showing a relationship between the intrinsic viscosity [η] and the absolute molecular weight M of the carboxyl group-containing polyurethane prepared in Synthetic

Example 5.

EMBODIMENT FOR CARRYING OUT THE INVENTION

The present invention will be described in detail hereinafter.
The thermosetting ink composition used in the present invention comprises a thermosetting resin (A) and optionally a curing accelerator (B), an organic solvent (C), an additive (D) and other components. The components constituting the thermosetting ink composition of the present invention will be described below.

Thermosetting resin (A)

The thermosetting resin (A) has a value "a" of less than 0.60 in the following formula (1).

$$[\eta] = K \times M^a \qquad (1)$$

In the formula (1), K is a constant number.
The formula (1) is a Mark-Houwink formula showing the relationship between the intrinsic viscosity [η] and the absolute molecular weight M of the resin, and the value "a" in the formula (1) generally shows a shape of a polymer chain. When the polymer chain has a random coil structure, the value "a" is liable to be 0.60 to 0.70. When the polymer chain has a branched structure, the value "a" is liable to be less than 0.60. Increasing the degree of branching, the value "a" further becomes a smaller value. That is, when the polymer chain becomes a strong crosslinked body and nearly a rigid spherical body by increasing the molecular density, the polymer is determined as a spherical body having a definite intrinsic viscosity independently of the molecular weight in the Mark-Houwink formula showing the relationship between the intrinsic viscosity [η] and the absolute molecular weight M of the resin and therefore the value "a" is asymptotically zero. When the polymer has a near rod shape, the value "a" is liable to be larger than 0.70.

When the value "a" of the formula (1) is less than 0.60, oozing and bleeding can be prevented at the time of screen-printing. The value "a" is preferably 0.40 to 0.59, more preferably 0.40 to 0.55. When the a value is too small, there is a possibility such that since the polymer is a string crosslinked body, that is, a nearly rigid spherical body, the polymer chain does not transform and thereby wrong conditions such as choking and the like are caused at the time of purifying the resin with filtration.

The value "a" is determined from a tilt of a straight line obtained by plotting the absolute molecular weight and the intrinsic viscosity of the thermosetting resin (A) on logarithmic axes. The specific method of determining the value "a" will be described in Example.

The thermosetting resin (A) used in the present invention is a carboxyl group-containing polyurethane.

<Carboxyl group-containing polyurethane>

The carboxyl group-containing polyurethane preferably used in the present invention has two or more carboxyl groups in one molecule and has a urethane bond formed by reacting a polyisocyanate compound with a polyol compound. The carboxyl group-containing polyurethane can be synthesized by reacting a polyisocyanate compound (a), a polyol compound (b), a carboxyl group-containing dihydroxy compound (c) and a three or more functional polyol (d). In the reaction, a monohydroxy compound (e) and/or a monoisocyanate compound (f) may be added as an end sealing agent.

Examples of the polyisocyanate compound are diisocyanates (a) such as 2, 4-trylene diisocyanate, 2, 6-tolylene diisocyanate, isophorone diisocyanate, 1,6-hexamethylene diisocyanate, 1,3-trimethylene diisocyanate, 1,4-tetramethylene diisocyanate, 2,2,4-trimethylhexamethylene diisocyanate, 2,4,4-trimethylhexamethylene diisocyanate, 1,9-nonamethylene diisocyanate, 1,10-decamethylene diisocyanate, 1,4-cyclohexane diisocyanate, 2,2'-diethylether diisocyanate, diphenylmethane-4,4'-diisocyanate, (o, m or p)-xylene diisocyanate, methylene bis(cyclohexylisocyanate), cyclohexane-1,3-dimethylene diisocyanate, cyclohexane-1,4-dimethylene diisocyanate, 1,5-naphthalene diisocyanate, p-phenylene diisocyanate,, 3,3'-methylene ditolylene-4,4'-diisocyanate, 4,4'-diphenylether diisocyanate, tetrachlorophenylene diisocyanate, norbornane diisocyanate and hydrogenated (1,3- or 1,4-)xylylene diisocyanate. These may be used singly or two or more may be combined for use.

Examples of the polyol compound (b) excluding the carboxyl group-containing dihydroxy compound (c) and the three or more functional polyol (d) are low molecular weight diol, polycarbonate diol, polyether diol, polybutadiene having a hydroxyl group at both ends, polyester diol, dimer diol, tricyclodecane dimethanol, cyclohexane dimethanol, straight-chain aliphatic diol having 4 or more carbon atoms. These may be used singly, or two or more may be combined for use. Among them, it is preferred to use polycarbonate diol from the viewpoint of softness, electric insulating properties and heat resistance.

Examples of (c) the carboxyl group-containing dihydroxy compound are 2,2-dimethylol propionic acid, 2,2,-dimethylol butanoic acid, N,N-bishydroxyethylglycine and N,N-bishydroxyethylalanine. These may be used singly, or two or more may be combined for use. It is preferred to use 2,2-dimethylol propionic acid and 2,2-dimethylol butanoic acid from the viewpoint of solubility in a solvent.

Examples of the three or more functional polyol (d) are trimethylol ethane, trimethylol propane, glycerin, pentaerythritol and dipentaerythritol. It is preferred to use trimethylol ethane, trimethylol propane and glycerin from the viewpoint of regulation for resin synthesis.

Examples of the monohydroxy compound (e) are 2-hydroxyethyl(meth)acrylate, hydroxypropyl(meth)acrylate, hydroxybutyl(meth)acrylate, cyclohexane dimethanol mono(meth)acrylate, caprolactones or oxidized alkylene adducts of the above (meth)acrylates, glycerin di(meth)acrylate, trimethylol di(meth)acrylate, pentaerythrilytol tri(meth)acrylate, dipentaerythritol penta(meth)acrylate, ditrimethylolpropane tri(meth)acrylate, allylalcohol, allyloxyethanol, glycolic acid, hydroxypivalic acid, methanol, ethanol, n-propanol, isopropanol, n-butanol, isobutanol, sec-butanol, t-butanol, amylalcohol, hexylalcohol and octylalcohol. These may be used singly, or two or more may be combined for use.

Examples of the monoisocyanate compound (f) are (meth)acryloyl oxyethyl isocyanate, phenyl isocyanate, hexyl isocyanate and dodecyl isocyanate. These may be used singly, or two or more may be combined for use.

The carboxyl group-containing polyurethane has a number average molecular weight of preferably 500 to 100,000, more preferably 8,000 to 30,000. The number average molecular weight is a value relative to polystyrene determined by a gel permeation chromatography (GPC). When the number average molecular weight of the carboxyl group-containing polyurethane is lower than the lower limit of the above range, the elongation, flexibility and strength of a cured film are sometimes damaged, while when it is over the upper limit of the above range, a cured film is rigid and the flexibility is sometimes lowered.

The carboxyl group-containing polyurethane has an acid value of preferably 5 to 150 mgKOH/g, more preferably 30 to 120 mgKOH/g. When the acid value is lower than the lower limit of the above range, the reactivity with the curing components is lowered and the heat resistance is sometimes damaged, while when it is over the upper limit of the above range, the alkali resistance of a cured film and properties as a resist such as electric insulating properties are sometimes lowered. The acid value of the resin is a value determined by titrating with a 0. 1N alcoholic potassium hydroxide solution using a phenolphthalene reagent as an indicator in accordance with JIS K0070.

The value "a" of the formula (1) in the thermosetting resin (A) can be determined to be less than 0.60, preferably 0.40 to 0.59 by adding the three or more functional polyol (d) in the carboxyl group-containing polyurethane and regulating the amount thereof. In the preparation of the carboxyl group-containing polyurethane, the three or more functional polyol (d) is added in an amount of preferably 0.3 % by mass to 10 % by mass based on the total amount of the raw material components. When the amount is not more than 0.3 % by mass, the resultant carboxyl group-containing polyurethane has an insufficient degree of branching and the effect of oozing and bleeding control at the time of printing is small. On the other hand, when it is not less than 10 % by mass, the handling properties are sometimes difficult by gelation caused at the time of synthesizing the carboxyl group-containing polyurethane.

In the synthesis of the carboxyl group-containing polyurethane having a value "a" in the above range by allowing the polyisocyanate compound (a) to react with the polyol compound (b), the carboxyl group-containing dihydroxy compound (c) and the three or more functional polyol (d), the amounts of the components (a), (b), (c) and (d) based on the total amount of the raw material components are as follows. The amount of the polyisocyanate compound (a) is preferably 10 to 50 % by mass. When the amount is less than the lower limit of the above range, the amount of polyol is too large in forming the urethane group and thereby the moisture absorption of a product is liable to be increased by the influence of a hydroxyl group. When it is over the upper limit of the above range, the amount of isocyanate is too large in forming the urethane group and thereby even after completion of the synthesis, reaction of the isocyanate groups is caused and the product is liable to be thickened.

The amount of the polyol compound (b) is preferably 30 to 80 % by mass. When the amount is lower than the lower limit of this range, the amount of isocyanate is too large in forming the urethane group and thereby even after completion of the synthesis, reaction of the isocyanate groups is caused and the product is liable to be thickened. When the amount is over the upper limit of the above range, the amount of polyol is too large in forming the urethane group and thereby the moisture absorption of a product is liable to be increased by the influence of a hydroxyl group.

The amount of the carboxyl group-containing dihydroxy compound (c) is preferably 2 to 30 % by mass. When the amount is lower than the lower limit of this range, the carboxyl group-containing polyurethane has a low acid value and thereby the reaction with the curing components is not caused to cause a possibility that a coating film formed by the present composition has stickiness. When it is over the upper limit of this range, the carboxyl group-containing polyurethane has a high acid value and a coating film is liable to be rigid.

The amount of the three or more functional polyol (d) is preferably 0.3 to 10 % by mass.

In the case of adding the monohydroxy compound (e) and the monoisocyanate compound (f), the amount of each component is preferably 0.1 to 3 % by mass based on the total amount of the raw material components. When the amount is lower than the lower limit of this range, the polymer chain terminates at the end of isocyanate and thereby even after completion of the synthesis, reaction of isocyanate groups is caused and a product is liable to be thickened. When the amount is over the upper limit of this range, an unreacted monomer is present and thereby a coating film formed by the present composition sometimes has stickiness.

<Thermosetting component>

As the thermosetting component, epoxy resins capable of reacting with the carboxyl group-containing polyurethane component can be used. Examples of the epoxy resins are epoxy compounds having two or more epoxy groups in one molecule, such as aliphatic glycydyl ether, bisphenol A type epoxy resin, hydrogenated bisphenol A type epoxy resin, brominated bisphenol A type epoxy resin, bisphenol F type epoxy resin, novolac type epoxy resin, phenol novolac type epoxy resin, cresol novolac type epoxy resin, N-glycidyl type epoxy resin, bisphenol A novolac type epoxy resin, chelate type epoxy resin, glyoxal type epoxy resin, amino group-containing epoxy resin, rubber modified epoxy resin, dicyclopentadiene phenolic type epoxy resin, silicon modified epoxy resin and ε-caprolactam modified epoxy resin. Furthermore, epoxy resins obtainable by introducing a halogen atom such as chlorine or bromine, a phosphorus atom and other atoms into the structure may be used in order to give flame retardant properties. Moreover, it is possible to use bisphenol S type epoxy resin, diglycidyl phthalate resin, heterocyclic epoxy resin, bixylenol type epoxy resin, biphenol type epoxy resin and tetraglycidyl xylenoyl ethane resin.

In the thermosetting ink composition used in the present invention, the above thermosetting components may be used singly, or two or more may be combined for use. The thermosetting components are preferably used in an amount such that the ratio of epoxy equivalent weight of the curing components to carboxyl group equivalent weight of the carboxyl group-containing polyurethane is 0.5 to 3.0. When the ratio of epoxy equivalent weight is lower than the lower limit of the above range, the electric insulating properties of the cured film formed from the thermosetting ink composition is sometimes insufficient. On the other hand, when it is over the upper limit of the above range, the shrinkage amount of the cured film is increased and the low warpage is liable to be deteriorated in the case of using the composition as an insulation protective film of a flexible printed circuit (FPC).

Curing accelerator (B)

The thermosetting ink composition used in the present invention may comprise the curing accelerator (B) optionally in order to accelerate the curing reaction. The properties such as adhesion, chemical resistance and heat resistance can be further improved by the use of the curing accelerator.

Examples of the curing accelerator (B) are imidazole derivatives such as 2-methylimidazol, 2-ethyl-4-methylimidazol, 2-undecylimidazol, 2-heptadecylimidazol, 2-phenylimidazol, 1-benzyl-2-methylimidazol, 1-cyanoethyl-2-methylimidazol, 1-cyanoethyl-2-ethyl-4-methylimidazol, 1-cyanoethyl-2-undecylimidazol, 1-cyanoethyl-2-phenylimidazol, 1-cyanoethyl-2-phenyl-4,5-dihydroxymethylimidazol, 1-cyanoethyl-2-undecylimidazolium trimeritate, 1-cyanoethyl-2-methylimidazolium trimeritate, 1-cyanoethyl-2-ethyl-4-methylimidazolium trimeritate, 1-cyanoethyl-2-phenylimidazolium trimeritate, 2,4-diamino-6-[2'-methylimidazolyl-(1')]-ethyl-s-triazine, 2,4-diamino-6-[2'-ethyl-4'-methylimidazolyl-(1')] -ethyl-s-tri azine, 2,4-diamino-6-[2'-undecylimidazolyl-(1')]-ethyl-s-triazine, 2,4-diamino-6-[2'-methylimidazolyl-(1')] -ethyl-s-triazine isocyanulic acid adduct, 2-phenyl-4-methyl-5-hydroxymethyl imidazole and 2-phenyl-4,5-dihydroxymethyl imidazole;

guanamines such as acetoguanamine and benzoguanamine;

polyamines such as diaminodiphenyl methane, m-phenylene diamine, m-xylene diamine, diamino diphenyl sulfone, dicyane diamide, urea, urea derivatives, melamine, 1,5-diazabicyclo[4.3.0]nonene-5 and its salts, and 1,8-diazabicyclo[5.4.0]undecene-7 and its salts;

their organic acid salts and/or epoxy adducts;

amine complexes of boron trifluoride;

triazine derivatives such as ethyldiamino-S-triazine, 2,4-diamino-S-triazine and 2,4-diamino-6-xylyl-S-triazine;

amines such as trimethylamine, triethanol amine, N,N-dimethyloctyl amine, N-benzyldimethyl amine, pyridine, N-methylmorpholine, hexa(N-methyl)melamine, 2,4,6-tris(dimethylamino phenol), tetramethylguanidine and m-aminophenol;

polyphenols such as polyvinylphenol, polyvinylphenol bromide, phenol novolac and alkylphenol novolac;

organic phosphines such as tributyl phosphine, triphenyl phosphine and tris-2-cyanoethyl phosphine;

phosphonium salts such as tri-n-butyl(2,5-dihydroxyphenyl)phosphonium bromide and hexadodecyl tributyl phosphonium chloride;

quaternary ammonium salts such as benzyltrimethyl ammonium chloride and phenyltributyl ammonium chloride;

polybasic acid anhydrides;

light cation polymerization catalysts such as diphenyliodonium tetrafluoroboroate, triphenyl sulfonium hexafluoro antimonite, 2,4,6-triphenyl thiopyrylium hexafluorophosphate, "Irgacure-261" manufactured by Ciba Geigy and "Optomer-SP-170" manufactured by Asahi Denka Co.;

styrene-anhydrous maleic acid resins; and

conventionally known curing agents or curing accelerators such as equimolar reactants of phenylisocyanate and dimethylamine, and equimolar reactants of dimethyl amine and an organic polyisocyanate e.g. tolylenediisocyanate and isophorone diisocyanate.

The curing accelerators may be used singly or two or more may be combined for use. The use of the curing accelerators in the present invention is not essential. When the curing is desirably accelerated particularly, the curing accelerators can be used in an amount of not more than 25 parts by mass based on 100 parts by mass of the thermosetting resin (A). The amount of over 25 parts by mass is unfavorable, because the amount of gas components caused from the resultant cured product is increased, and further curing is accelerated to lower the working life of the mixture remarkably.

Organic solvent (C)

The thermosetting ink composition used in the present invention is obtainable by dissolving or dispersing the thermosetting resin (A), and optionally the curing accelerator (B), the organic solvent (C) and the additive (D) using a mixing machine such as disper, kneader, 3-roll mill or bead mill. In this procedure, in order to dissolve or disperse the thermosetting resin (A) and the additive (D) easily, or regulate the viscosity applicable for coating, it is possible to use the organic solvent (C) inert to the functional group contained in the composition.

# EP 2 380 937 B1

Examples of the organic solvent (C) are toluene, xylene, ethylbenzene, nitrobenzene, cyclohexane, isophorone, diethylene glycol dimethylether, ethylene glycol diethylether, propyleneglycol methylether acetate, propyleneglycol ethylether acetate, dipropylene glycol methylether acetate, diethylene glycol ethylether acetate, diethyleneglycol monobutylether acetate, 3-methoxy-3-methylbutylacetate, methyl methoxypropionate, ethyl methoxypropionate, methyl ethoxypropionate, ethyl ethoxypropionate, ethyl acetate, n-butyl acetate, isoamyl acetate, ethyl lactate, acetone, methylethyl ketone, cyclohexanone, N,N-dimethylformamide, N,N-dimethylacetoamide, N-methyl pyrrolidone, γ-butylolactone, dimethyl sulfoxide, chloroform, petroleum naphtha and methylene chloride. These may be used singly or two or more may be combined for use.

Additive (D)

The thermosetting composition used in the present invention may contain conventionally known various additives. Examples thereof are inorganic fillers such as barium sulfate, talc, calcium carbonate, alumina, glass powder, quartz powder and silica; fiber-reinforces materials such as glass fiber, carbon fiber and boron nitride fiber; colorants such as titanium oxide, zinc oxide, carbon black, iron black, organic pigments and organic dyes; antioxidants such as hindered phenol compounds, phosphorus compounds and hindered amine compounds; and ultraviolet ray absorbers such as benzotriazole compounds and benzophenone compounds. Moreover, the thermosetting composition may contain an ion exchanger, a viscosity regulator, a flame retardant, an antibacterial agent, a mold proofing agent, an antioxidant, an antistatic agent, a plasticizer, a lubricant, a foaming agent, a defoaming agent and a leveling agent according to the use thereof. The amount of the additive (D) is not particularly limited. The amount is preferably not more than 30 parts by weight, more preferably not more than 20 parts by weight based on 100 parts by weight of the thermosetting resin (A).

The thermosetting ink composition used in the present invention comprises the above-described components. The thermosetting ink composition used in the present invention can be used as a resist ink for protecting wiring from insulation, such as solder resist.

The resist ink for protecting wiring from insulation may contain only the above thermosetting ink composition, or further may contain components other than the thermosetting ink composition. The resist ink for protecting wiring from insulation is obtainable by blending the components of the thermosetting ink composition and optionally other components, and dissolving or dispersing by the mixing machine described above, or it is obtainable by preparing the thermosetting ink composition and then adding the other components and mixing uniformly.

The cured product is obtainable by curing the thermosetting ink composition used in the present invention. The cured product is used as films such as solder resist and surface protective films for wiring circuit.

The cured product is produced by applying the thermosetting ink composition on the surface of an object for protection with screen printing and the like, and then drying or not drying, and thermally curing. The heating is carried out usually at 50 to 150°C for 20 to 120 min.

An insulating protective film is a film for protecting an object in order to secure electric insulating properties, and is formed by applying the thermosetting ink composition on an object and thermally curing, or is formed previously for adhering to an object.

The insulating protective film comprises the cured product used in the present invention. The insulating protective film is formed by applying the thermosetting ink composition on the surface of an object, drying and thermally curing, or is formed by thermally curing the thermosetting ink composition in a film shape previously for adhering to an object.

The cured product obtainable by curing the thermosetting ink composition covers a substrate of a flexible printed wiring board or a chip on film (COF) partly or wholly to form the flexible printed wiring board or chip on film (COF).

EXAMPLE

The present invention will be described in more detail with reference to the following examples below, but it should not be limited by the examples.

<Method for determining value "a" in the Mark-Houwink formula>

The structure and conditions of GPC device are as follows. Pump: Alliance (Trade Mark) 2695 manufactured by Waters Co. Differential refractometer: 2410 manufactured by Waters Co. Multi-angle light scattering detector: DAWN (Trade Mark) and HELEOS 8+ (Trade mark) manufactured by Wyatt Co.

Intrinsic viscosity detector: ViscoStar (Trade Mark) manufactured by Wyatt Co.
Column: Shodex (Trade Mark) three columns of GPC KF805L, GPC KF803L and GPCKF802.5L manufactured by SHOWA DENKO K.K. were connected and used.
Solvent: tetrahydrofuran

The absolute molecular weight and the intrinsic viscosity were measured in a sample concentration of 0.01 mg/ml, at a flow rate of 1.0 ml/min at a measuring temperature of 25°C.

The absolute molecular weight is determined by GPC for each fraction continuously separated based on molecular weight. Specifically, the absolute molecular weight is a value obtainable by extrapolating a scattering light intensity to zero from the scattering light strength and the scattering angle determined by the multi-angle light scattering detector.

The intrinsic viscosity is determined for each fraction separated on molecular weight continuously with GPC.

Specifically the intrinsic viscosity is determined from a differential pressure between the flow path of only the solvent and the flow path of the solvent and the sample.

The determinations of the absolute molecular weight and the intrinsic viscosity are carried out by Software Atras provided in the detector.

The value "a" is determined by plotting the absolute molecular weight and the intrinsic viscosity thus obtained on a logarithmic axis and calculating from the tilt of the resultant straight line with the least-squares method.

Synthetic Example 1

To a reaction vessel equipped with a stirrer, a thermometer and a condenser, 219.8 g of "C-1015N" (polycarbonate diol having a raw material diol molar ratio that 1,9-nonane diol : 2-methyl-1,8-octane diol = 15 : 85 , and molecular weight of 991) manufactured by Kuraray Co., as a polyol compound, 42.2 g of 2,2-dimethylol butanoic acid manufactured by Nippon Kasei Chemical Co., Ltd. as a carboxyl group-containing dihydroxy compound, 2.4 g of trimethylol ethane manufactured by Mitsubishi Gas Chemical Company, Inc. as a three or more functional polyol and 600.0 g of diethylene glycol monoethylether acetate manufactured by Daicel Chemical Industries, Ltd. as a solvent were fed and all the raw materials were dissolved by heating to 100°C.

The temperature of the reaction solution was lowered to 90 °C, and 134.3 g of methylene bis(4-cyclohexylisocyanate) "Desmodur-W" (Trade Mark) manufactured by Sumika Bayer Urethane Co., as polyisocyanate was dropped to the solution over 30 min with a dropping funnel. The reaction was carried out at 120°C for 6 hr and it was confirmed that isocyanate was almost quenched. Thereafter, 2.1 g of isobutanol manufactured by Wako Pure Chemical Industries was dropped to the solution and the reaction was further carried out at 90°C for 3 hr.

The resultant carboxyl group-containing polyurethane had a number average molecular weight of 11000 and an acid value of the solid component of 40.0 mg-KOH/g.

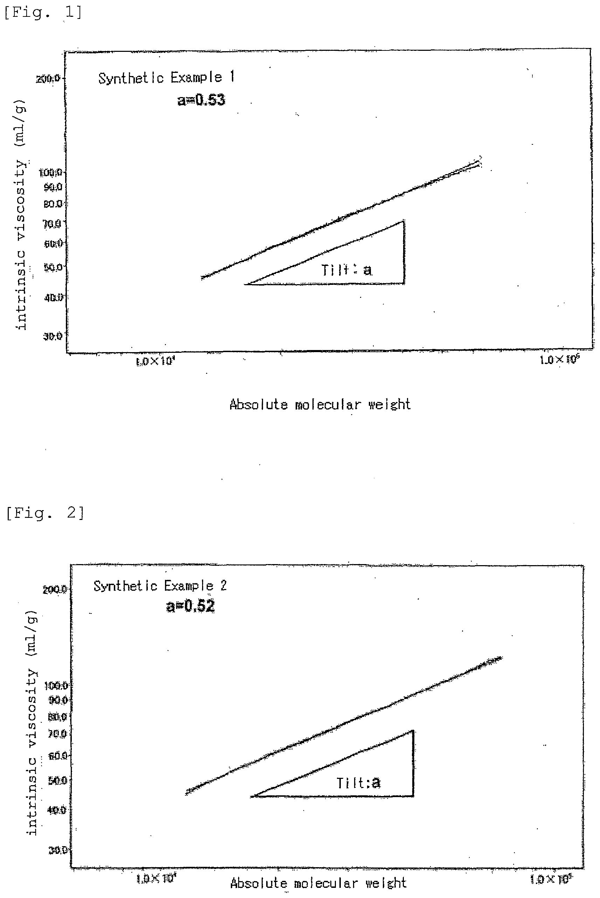

With respect to the carboxyl group-containing polyurethane, the absolute molecular weight and the intrinsic viscosity were determined by the above methods. The absolute molecular weight and the intrinsic viscosity were plotted on a logarithmic axis and the resultant graph was shown in Fig. 1. The value "a" in the Mark-Houwink formula showing the relationship between the intrinsic viscosity $[\eta]$ and the absolute molecular weight M of the resin was 0.53 from Fig. 1.

In the preparation of the carboxyl group-containing polyurethane in Synthetic Example 1, the amount of the three or more functional polyol (d) fed was 0.60 % by mass based on the total amount of the raw material components.

Synthetic Example 2

To a reaction vessel equipped with a stirrer, a thermometer and a condenser, 177. 4 g of "UH-CARB80" (polycarbonate diol having a number average molecular weight of 800 derived from 1,6-hexane diol) manufactured by Ube Industries Ltd., as a polyol compound, 38.2 g of 2,2-dimethylol propionic acid manufactured by Nippon Kasei Chemical Co. , Ltd. as a carboxyl group-containing dihydroxy compound, 2.7 g of trimethylol propane manufactured by Mitsubishi Gas Chemical Company, Inc. as a three or more functional polyol and 600.0 g of diethylene glycol monoethylether acetate manufactured by Daicel Chemical Industries, Ltd. as a solvent were fed and all the raw materials were dissolved by heating to 100 °C.

The temperature of the reaction solution was lowered to 90 °C, and 113.6 g of isophorone isocyanate "Desmodur-I" (Trade Mark) manufactured by Sumika Bayer Urethane Co., as polyisocyanate was dropped to the solution over 30 min with a dropping funnel. The reaction was carried out at 120°C for 6 hr and it was confirmed that isocyanate was almost quenched. Thereafter, 2.1 g of isobutanol manufactured by Wako Pure Chemical Industries was dropped to the solution and the reaction was further carried out at 90°C for 3 hr.

The resultant carboxyl group-containing polyurethane had a number average molecular weight of 11000 and an acid value of the solid component of 40.0 mg-KOH/g.

With respect to the carboxyl group-containing polyurethane, the absolute molecular weight and the intrinsic viscosity were determined by the above methods. The absolute molecular weight and the intrinsic viscosity were plotted on a logarithmic axis and the resultant graph was shown in Fig. 2. The value "a" in the Mark-Houwink formula showing the relationship between the intrinsic viscosity $[\eta]$ and the absolute molecular weight M of the resin was 0.52 from Fig. 2.

In the preparation of the carboxyl group-containing polyurethane in Synthetic Example 2, the amount of the three or more functional polyol (d) fed was 0.81 % by mass based on the total amount of the raw material components.

Synthetic Example 3

To a reaction vessel equipped with a stirrer, a thermometer and a condenser, 443.5 g of "UH-CARB200" (Trade Mark, polycarbonate diol having a number average molecular weight of 2000 derived from 1, 6-hexane diol) manufactured by Ube Industries, Ltd, as a polyol compound, 42.2 g of 2, 2-dimethylol butanoic acid manufactured by Nippon Kasei Chemical Co., Ltd. as a carboxyl group-containing dihydroxy compound, 2.7 g of trimethylol propane manufactured by Mitsubishi Gas Chemical Company, Inc. as a three or more functional polyol and 600.0 g of diethylene glycol monoethylether acetate manufactured by Daicel Chemical Industries, Ltd. as a solvent were fed and all the raw materials were dissolved by heating to 100°C.

The temperature of the reaction solution was lowered to 90 °C, and 134.3 g of methylene bis(4-cyclohexylisocyanate) "Desmodur-W" (Trade Mark) manufactured by Sumika Bayer Urethane Co., as polyisocyanate was dropped to the solution over 30 min with a dropping funnel. The reaction was carried out at 120°C for 6 hr and it was confirmed that isocyanate was almost quenched. Thereafter, 2.1 g of isobutanol manufactured by Wako Pure Chemical Industries was dropped to the solution and the reaction was further carried out at 90°C for 3 hr.

The resultant carboxyl group-containing polyurethane had a number average molecular weight of 11000 and an acid value of the solid component of 40.0 mg-KOH/g.

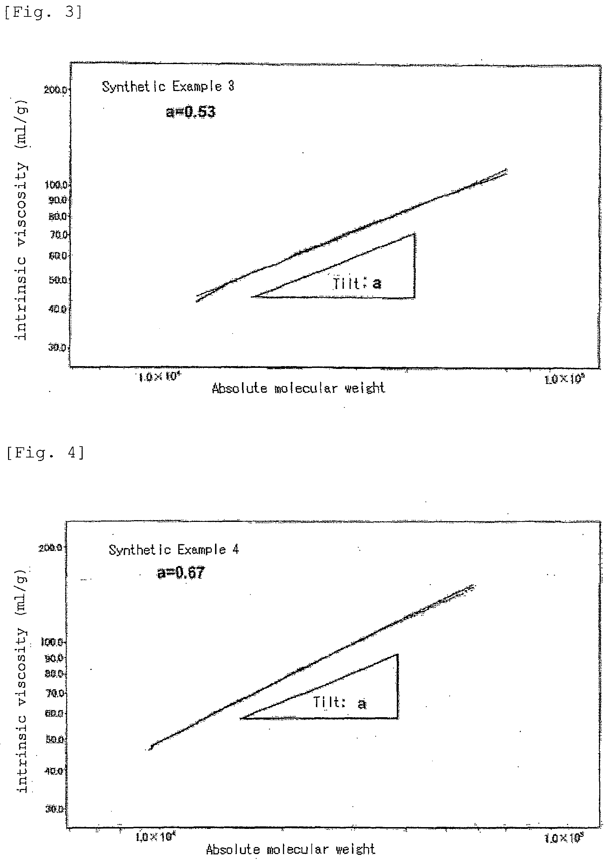

With respect to the carboxyl group-containing polyurethane, the absolute molecular weight and the intrinsic viscosity were determined by the above methods. The absolute molecular weight and the intrinsic viscosity were plotted on a logarithmic axis and the resultant graph was shown in Fig. 3. The value "a" in the Mark-Houwink formula showing the relationship between the intrinsic viscosity [$\eta$] and the absolute molecular weight of the resin was 0.53 from Fig. 3.

In the preparation of the carboxyl group-containing polyurethane in Synthetic Example 3, the amount of the three or more functional polyol (d) fed was 0.43 % by mass based on the total amount of the raw material components.

Synthetic Example 4

To a reaction vessel equipped with a stirrer, a thermometer and a condenser, 219.8 g of "C-1015N" (polycarbonate diol having a raw material diol molar ratio that 1,9-nonane diol : 2-methyl-1,8-octane diol = 15 : 85 , and molecular weight of 991) manufactured by Kuraray Co., as a polyol compound, 42.2 g of 2,2-dimethylol butanoic acid manufactured by Nippon Kasei Chemical Co., Ltd. as a carboxyl group-containing dihydroxy compound and 600.0 g of diethylene glycol monoethylether acetate manufactured by Daicel Chemical Industries, Ltd. as a solvent were fed and all the raw materials were dissolved by heating to 100 °C.

The temperature of the reaction solution was lowered to 90 °C, and 134.3 g of methylene bis(4-cyclohexylisocyanate "Desmodur-W" (Trade Mark) manufactured by Sumika Bayer Urethane Co., as polyisocyanate was dropped to the solution over 30 min with a dropping funnel. The reaction was carried out at 120 °C for 6 hr and it was confirmed that isocyanate was almost quenched. Thereafter, 2.1 g of isobutanol manufactured by Wako Pure Chemical Industries was dropped to the solution and the reaction was further carried out at 90 °C for 3 hr.

The resultant carboxyl group-containing polyurethane had a number average molecular weight of 10000 and an acid value of the solid component of 40.0 mg-KOH/g.

With respect to the carboxyl group-containing polyurethane, the absolute molecular weight and the intrinsic viscosity were determined by the above methods. The absolute molecular weight and the intrinsic viscosity were plotted on a logarithmic axis and the resultant graph was shown in Fig. 4. The value "a" in the Mark-Houwink formula showing the relationship between the intrinsic viscosity [$\eta$] and the absolute molecular weight M of the resin was 0.67 from Fig. 4.

Synthetic Example 5

To a reaction vessel equipped with a stirrer, a thermometer and a condenser, 177.4 g of "UH-CARB80" (Trade Mark, polycarbonate diol having a number average molecular weight of 800 derived from 1,6-hexane diol) manufactured by Ube Industries, Ltd, as a polyol compound, 38.2 g of 2,2-dimethylol propionic acid manufactured by Nippon Kasei Chemical Co. , Ltd. as a carboxyl group-containing dihydroxy compound, and 600.0 g of diethylene glycol monoethylether acetate manufactured by Daicel Chemical Industries, Ltd. as a solvent were fed and all the raw materials were dissolved by heating to 100 °C.

The temperature of the reaction solution was lowered to 90 °C, and 113.6 g of isophorone diisocyanate "Desmodur-I" (Trade Mark) manufactured by Sumika Bayer Urethane Co., as polyisocyanate was dropped to the solution over 30 min with a dropping funnel. The reaction was carried out at 120 °C for 6 hr and it was confirmed that isocyanate was almost quenched. Thereafter, 2.1 g of isobutanol manufactured by Wako Pure Chemical Industries was dropped to the solution and the reaction was further carried out at 90°C for 3 hr.

The resultant carboxyl group-containing polyurethane had a number average molecular weight of 11000 and an acid value of the solid component of 40.0 mg-KOH/g.

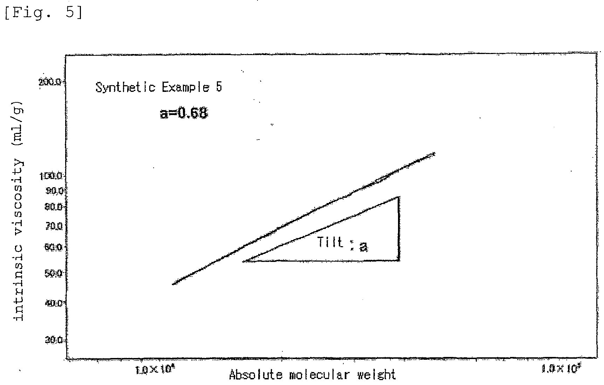

With respect to the carboxyl group-containing polyurethane, the absolute molecular weight and the intrinsic viscosity were determined by the above methods. The absolute molecular weight and the intrinsic viscosity were plotted on a logarithmic axis and the resultant graph was shown in Fig. 5. The value "a" in the Mark-Houwink formula showing the relationship between the intrinsic viscosity $[\eta]$ and the absolute molecular weight of the resin was 0.68 from Fig. 5.

Example 1

The carboxyl group-containing polyurethane solution prepared in Synthetic Example 1 (having a solid component concentration of 45 % by mass) was blended with an epoxy resin ("Epicoat" Trade Mark 828EL manufactured by Japan Epoxy Resin Co.,) in an amount of 37.5 parts by weight based on 100 parts by mass of the polyurethane solid component, which amount was equivalent to that the amount of the epoxy group was 0. 9 equivalent weight based on the carboxyl group of the polyurethane, and melamine in an amount of 3 parts by mass as a curing agent. Subsequently, the composition of these components was kneaded by passing through a three-roll mill (Model: RIII-1RM-2 manufactured by Kodaira Seisakusho Co., Ltd.) three times to prepare a resist ink.

Example 2

The procedure of Example 1 was repeated except that the carboxyl group-containing polyurethane solution of Example 1 was replaced with the carboxyl group-containing polyurethane solution prepared in Synthetic Example 2, to prepare a resist ink.

Example 3

The procedure of Example 1 was repeated except that the carboxyl group-containing polyurethane solution of Example 1 was replaced with the carboxyl group-containing polyurethane solution prepared in Synthetic Example 3, to prepare a resist ink.

Comparative Example 1

The procedure of Example 1 was repeated except that the carboxyl group-containing polyurethane solution of Example 1 was replaced with the carboxyl group-containing polyurethane solution prepared in Synthetic Example 4, to prepare a resist ink.

Comparative Example 2

The procedure of Comparative Example 1 was repeated except that 5 parts by mass of talc (SG-95 Micro Ace Trade Mark manufactured by Nippon Talc Co.) was added based on 100 parts by mass of the polyurethane solid component, to prepare a resist ink.

Comparative Example 3

The procedure of Example 1 was repeated except that the carboxyl group-containing polyurethane solution of Example 1 was replaced with the carboxyl group-containing polyurethane solution prepared in Synthetic Example 5 and 5 parts by mass of silica (AEROSIL #380 Trade Mark manufactured by Nippon Aerosil Co. , Ltd. , was added based on 100 parts by mass of the polyurethane solid component at the time of blending, to prepare a resist ink.

Comparative Example 4

The procedure of Comparative Example 3 was repeated except that 5 parts by mass of fine particle silica (Chrotone SP-03B Trade Mark) manufactured by Fuso Chemical Co., Ltd.) was added as an additive based on 100 parts by weight of the polyurethane solid component at the time of blending, to prepare a resist ink.

[Evaluation]

Using the resist inks prepared in Examples 1 to 3 and Comparative Examples 1 to 4, the printability, the electric insulating properties and the adhesion to an object to be coated were evaluated in the following manners. The evaluation results are shown in Table 1.

<Printability>

On IPC-A (comb-like pattern) of commercially available substrate (IPC standard), a resist ink was applied by screen-printing with #100 mesh polyester plate so that the thickness from the polyimide surface after drying was 15 $\mu$m, and dried at 80°C for 30 min. Thereafter, it was cured thermally at 150°C for 1 hr. After the curing, the fine line part was observed with a microscope, and the bleeding amount, namely, the distance between the printed end surface and the top where the ink was oozing was measured.

<Electric insulating reliability>

On IPC-C (comb-like pattern) of commercially available substrate (IPC standard), a resist ink was applied by screen-printing with #100 mesh polyester plate, and dried at 80 °C for 30 min. Thereafter, it was cured thermally at 150 °C for 1 hr. The resultant substrate was put at 85 °C at a relative humidity of 85%. A 100 V bias voltage was applied on the substrate and the substrate was allowed to stand for 2000 hr. The electric insulating properties were evaluated on the substrate in the following standard.

A: The declines in the migration and insulating resistance value are not observed.
B: The declines in the migration and insulating resistance value are observed for a period of time of over 1000 hr and not more than 2000 hr.
C: The declines in the migration and insulating resistance value are observed for a period of time of not more than 1000 hr.

<Adhesion>

On a polyimide film (Kapton (Trade Mark) 300EN, manufactured by DuPont-Tray Co., Ltd.) formed on a copper substrate, a resist ink was applied by screen printing with #100 mesh polyester plate so that the thickness from the substrate after drying was 15 $\mu$m, and dried at 80 °C for 30 min. Thereafter, it was cured thermally at 150 °C for 1 hr. The resultant coating film was evaluated in accordance with JIS K5600 adhesion (cross cut method). That is, 100 grid patterns were cut in this coating film with a distance 1 mm and an about 75 mm length tape was adhered on the grid part and torn at an angle of about 60° for a period of time of 0.5 to 1.0 sec. The peeling tape manufactured by Nitto Co., Ltd. was used and the adhesion was evaluated in the following standard.
A: The grids completely remain.

B: The number of the grids remained is not less than 50 and less than 100.

C: The number of the grids remained is not less than 50.

Table 1

| | | Resist ink | | Value "a" in Mark-Houwink formula | Properties | | |
|---|---|---|---|---|---|---|---|
| | | 3-functional polyole amount at synthesis of carboxyl group-containing polyurethane (mass%) | Inorganic filler | | Printability Bleeding length | Electric Insulating properties | Adhesion |
| | Ex. 1 | 0.60 | none | 0.53 | 43 $\mu$m | A | A |
| | Ex. 2 | 0.81 | none | 0.52 | 45 $\mu$m | A | A |
| | Ex. 3 | 0.43 | none | 0.53 | 40 $\mu$m | A | A |
| | Compar. Ex. 1 | 0 | none | 0.67 | 150 $\mu$m | A | A |
| | Compar. Ex. 2 | 0 | talc | 0.67 | 40 $\mu$m | C | B |

(continued)

| | Resist ink | | Value "a" in Mark-Houwink formula | Properties | | |
|---|---|---|---|---|---|---|
| | 3-functional polyole amount at synthesis of carboxyl group-containing polyurethane (mass%) | Inorganic filler | | Printability Bleeding length | Electric Insulating properties | Adhesion |
| Compar. Ex. 3 | 0 | silica | 0.68 | 43 $\mu$m | B | C |
| Compar. Ex. 4 | 0 | spherecal silica | 0.68 | 73 $\mu$m | C | C |

From the relationship between the value "a" and printability in Examples 1 to 3 and Comparative Example 1, it is said that when the value "a" is less than 0.60, the bleeding length can be made to be not more than 100 $\mu$m.

**Claims**

1.  A flexible printed wiring board obtainable by covering a part or all surface of a substrate with a thermosetting ink composition and curing the thermosetting ink composition to obtain a cured product, the thermosetting ink composition comprising a thermosetting resin (A) which has a value "a" of less than 0.60 in the following formula (1) showing the relationship between the intrinsic viscosity [η] and the absolute molecular weight M of the resin, wherein the thermosetting resin (A) is a carboxyl group-containing polyurethane obtainable by reacting:

    (a) a polyisocyanate compound,
    (b) a polyol compound excluding (c) a carboxyl group-containing dihydroxy compound and (d) a three or more functional polyol, both which are described below, wherein the polyol compound is a polycarbonate diol,
    (c) the carboxyl group-containing dihydroxy compound and (d) the three or more functional polyol:

$$[\eta] = K \times M^a \qquad (1)$$

    wherein K is a constant number.

2.  A chip on film (COF) obtainable by covering a part or all surface of a substrate with the thermosetting ink composition as defined in claim 1 and curing the thermosetting ink composition.

3.  An electronic part comprising the cured product as defined in claim 1.

**Patentansprüche**

1.  Gedruckte Schaltung, erhältlich durch Bedecken eines Teils oder der gesamten Oberfläche eines Substrats mit einer wärmehärtbaren Druckfarbenzusammensetzung und Härten der wärmehärtbaren Druckfarbenzusammensetzung, um eine gehärtetes Produkt zu erhalten, wobei die wärmehärtbare Druckfarbenzusammensetzung ein wärmehärtbares Harz (A) umfasst, welches einen Wert "a" von weniger als 0,60 in der folgenden Formel (1) hat, welche die Beziehung zwischen der inneren Viskosität [η] und dem absoluten Molekulargewicht M des Harzes angibt, wobei:

    das thermoplastische Harz (A) ein Carboxylgruppe(n) enthaltendes Polyurethan ist, erhältlich durch Umsetzen:

    (a) einer Polyisocyanatverbindung,
    (b) einer Polyolverbindung, ausgenommen (c) eine Carboxylgruppe(n) enthaltende Dihydroxyverbindung und (d) eines drei- oder höherfunkionalen Polyols, die beide unten beschrieben sind, wobei die Polyolverbindung ein Polycarbonatdol ist,
    (c) der Carboxylgruppe(n) enthaltenden Dihydroxyverbindung und
    (d) des drei- oder höherfunktionalen Polyols:

$$[\eta] = K \times M^a \qquad (1),$$

worin K eine konstante Zahl ist.

2.  Chip on Film (COF), erhältlich durch Bedecken eines Teils oder der gesamten Oberfläche eines Substrats mit der in Anspruch 1 definierten wärmehärtbaren Druckfarbenzusammensetzung und Härten der wärmehärtbaren Druckfarbenzusammensetzung.

3.  Elektronisches Bauteil, welches das in Anspruch 1 definierte gehärtete Produkt umfasst.


**Revendications**

1.  Carte de circuit imprimé souple pouvant être obtenue en recouvrant une partie ou la totalité de la surface d'un substrat avec une composition d'encre thermodurcissable et en faisant durcir la composition d'encre thermodurcissable pour obtenir un produit durci, la composition d'encre thermodurcissable comprenant une résine thermodurcissable (A) qui présente une valeur "a" inférieure à 0,60 dans la formule suivante (1) qui montre la relation entre la viscosité intrinsèque [η] et le poids moléculaire absolu M de la résine, dans laquelle
la résine thermodurcissable (A) est un polyuréthane contenant des groupes carboxyles pouvant être obtenu en faisant réagir:

    (a) un composé de polyisocyanate,
    (b) un composé polyol excluant (c) un composé dihydroxy contenant des groupes carboxyles et (d) un polyol trifonctionnel, ou plus, les deux étant décrits ci-dessous, dans lequel le composé polyol est un diol de polycarbonate,
    (c) le composé dihydroxy contenant des groupes carboxyles; et
    (d) le polyol trifonctionnel, ou plus:

$$[\eta] = K \times M^a \qquad (1)$$

    dans laquelle K est un nombre constant.

2.  Puce sur film (COF) pouvant être obtenue en recouvrant une partie ou la totalité de la surface d'un substrat avec la composition d'encre thermodurcissable selon la revendication 1 et en faisant durcir la composition d'encre thermodurcissable.

3.  Pièce électronique comprenant le produit durci selon la revendication 1.

[Fig. 1]

Absolute molecular weight

[Fig. 2]

[Fig. 3]

[Fig. 4]

[Fig. 5]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003113338 A
- JP 2008214413 A
- JP 2007100038 A
- WO 2007125806 A1
- WO 0236697 A1
- WO 03006561 A2
- EP 0844261 A1